# EUROPÄISCHE PATENTSCHRIFT

(11) **EP 0 753 180 B1**
(45) Veröffentlichungstag und Bekanntmachung des Hinweises auf die Patenterteilung: **24.01.2001**
(21) Anmeldenummer: 95913866.0
(22) Anmeldetag: 26.03.1995
(51) Int. Cl.: G06K 19/077, H01F 41/04, H01F 41/10

(54) **VERFAHREN ZUR HERSTELLUNG EINER CHIPKARTE SOWIE CHIPKARTE**
METHOD OF MANUFACTURING A CHIP CARD, AND CHIP CARD THUS PRODUCED
PROCEDE DE PRODUCTION D'UNE CARTE A PUCE ET CARTE A PUCE AINSI REALISEE

(30) Priorität: 28.03.1994 DE 4410732
(43) Veröffentlichungstag der Anmeldung: 15.01.1997
(73) Patentinhaber: Finn, David, 87629 Füssen-Weissensee (DE); Rietzler, Manfred, 87616 Marktoberdorf (DE)
(72) Erfinder: Finn, David, 87629 Füssen-Weissensee (DE); Rietzler, Manfred, 87616 Marktoberdorf (DE)
(74) Vertreter: Böck, Bernhard, Dipl.-Ing.
(86) Internationale Anmeldenummer: DE9500416
(87) Internationale Veröffentlichungsnummer: WO9526538

(56) Entgegenhaltungen:
- WO-A-91/16718
- WO-A-93/09551
- WO-A-93/18493
- WO-A-93/20537

## Beschreibung

Die vorliegende Erfindung betrifft ein Verfahren zur Herstellung einer zumindest einen Chip und eine Spule aufweisenden Transpondereinheit, insbesondere einer Chipkarte, bei dem der Chip und die Spule auf einem gemeinsamen Substrat angeordnet werden und die Ausbildung der Spule durch Verlegung eines Spulendrahts sowie die Verbindung von Spulendrahtenden mit Anschlußflächen des Chips auf dem Substrat erfolgt.

Bei den bisher bekannten Verfahren zur Herstellung von Chipkarten erfolgt die Bereitstellung von Spulen beispielsweise auf einem Filmträger, auf den die einzelnen Spulenwindungen im Ätzverfahren aufgebracht sind, wie in der EP-A2-0 481 776 gezeigt, oder auch in Form von separat ausgebildeten, zuvor im Wickelverfahren hergestellten Spulen, die als Einheit mit dem Chip auf ein Kartensubstrat aufgebracht oder als einzelnes Bauteil appliziert werden und auf dem Substrat mit dem Chip verbunden werden müssen.

Das vorgenannte Ätzverfahren zur Applikation von Spulenwindungen auf einem Substrat ist sehr aufwendig und verfahrensbedingt nur für Spulen mit einer relativ geringen Kupferdichte geeignet, so daß hiermit versehene Transpondereinheiten auch nur über eine entsprechend geringe Sendeleistung verfügen. Die Verwendung von Wickelspulen zur Herstellung eines Transponders macht ein aufwendiges Spulenhandling bei der Zuführung und der Applikation der Spulen, sowie ein nachträgliches Verbacken oder Verkleben der Spule mit dem Substrat erforderlich. Hierdurch sind neben der Durchführung des Wickelvorgangs zur Ausbildung der Spule weitere zusätzliche Arbeits- bzw. Handhabungsschritte notwendig, um ausgehend von einer Wickelspule eine Transpondereinheit zu bilden. Hierdurch erweist sich auch dieses Verfahren insgesamt als komplex und daher aufwendig sowie kostenintensiv in der Durchführung.

Aus der W0-A-91 16718 ist ein Verfahren zur Anordnung einer zumindest einen Chip und eine Drahtspule aufweisenden Transpondereinheit auf einem Substrat bekannt, bei dem der Chip und die Drahtspule auf dem gemeinsamen Substrat angeordnet werden und die Verbindung von Spulendrahtenden mit Anschlußflächen des Chips auf dem Substrat erfolgt. Als Drahtspule wird bei dem bekannten Verfahren eine sogenannte "Wickelspule" verwendet, deren Herstellung unabhängig von dem Substrat erfolgt und die nach Fertigstellung mit dem Substrat verbunden wird.

Aus der WO-A-93 20537 ist ein Verfahren zur Herstellung einer Chipkarte bekannt, bei dem, die Herstellung einer mit dem Chip kontaktierten Drahtspule ebenfalls in einem Wickelverfahren erfolgt und die Drahtspule nach Herstellung mit einem zur Aufnahme des Chips dienenden Substrats verbunden wird.

Der vorliegenden Erfindung liegt die Aufgabe zugrunde, ein Verfahren zur Anordnung einer zumindest einen Chip und eine Drahtspule aufweisenden Transpondereinheit auf einem Substrat sowie eine nach einem derartigen Verfahren hergestellte Chipkarte vorzuschlagen, das eine vereinfachte Herstellung von Chipkarten ermöglicht.

Die vorliegende Erfindung wird durch ein Verfahren mit den Merkmalen des Anspruchs 1 und eine Chipkarte mit den Merkmalen des Anspruchs 4 gelöst.

Bei dem erfindungsgemäßen Verfahren erfolgt die Ausbildung der Spule durch Verlegung eines Spulendrahts in einer Verlegeebene auf dem Substrat unter zumindest stellenweiser Verbindung des Spulendrahts mit dem Substrat.

Durch unmittelbares Verlegen der Spulendrahtwindungen auf dem Substrat wird die Bereitstellung einer zuvor gefertigten Wickelspule und deren Handhabung sowie Applikation auf dem Chip überflüssig. Vielmehr erfolgt die Ausbildung der Spule auf dem Substrat selbst, was darüber hinaus den Vorteil aufweist, daß die Ausbildung der Spule und die Verbindung von Spulendrahtenden mit den Anschlußflächen des Chips ineinanderübergehend, quasi in einem gemeinsamen Arbeitsgang, erfolgen können.

Besonders vorteilhaft ist es, wenn zur Durchführung des Verfahrens zunächst eine Verbindung eines Spulendrahtendes mit einer ersten Anschlußfläche des Chips erfolgt, nachfolgend das Verlegen der Spulendrahtwindungen auf dem Substrat durchgeführt wird, und schließlich die Verbindung des laufenden Spulendrahtendes mit einer zweiten Anschlußfläche des Chips erfolgt. Gleichzeitig mit dem Verlegen des Spulendrahts zur Ausbildung der Spule erfolgt zumindest stellenweise eine Verbindung des Spulendrahts mit dem Substrat, so daß die auf dem Substrat verlegte Spule formhaltig wird.

Hierdurch wird außer dem separaten Wickelvorgang zur Ausbildung einer konventionellen Wickelspule bei der "Verlegespule" auch das bekannte, bei konventionellen Wickelspulen erforderliche "Verbacken" der einzelnen Spulendrahtwindungen miteinander überflüssig.

In ähnlicher Weise, wie bei dem Verlegen des Spulendrahts eine Verbindung des Spulendrahts mit dem Substrat erfolgt, kann auch bei der Applikation des Chips auf dem Substrat eine Verbindung des Chips mit dem Substrat erfolgen. Hierdurch wird die Ausbildung von besonderen positionierenden Aufnahmen auf dem Substrat überflüssig. Vielmehr kann die gesamte Transpondereinheit auf einer unpreparierten, ebenen Oberfläche des Substrats appliziert werden.

Die Verbindung des Spulendrahts oder des Chips kann mittels Thermokompression, also Erweichen der Oberfläche des Substrats durch Erwärmung und Eindrücken des Spulendrahts bzw. des Chips, oder auch durch andere geeignete Applikationsmöglichkeiten, wie etwa durch "Einreiben" in die Oberfläche mittels Ultraschalleinwirkung, erfolgen.

Zur Ausführung der Verlegefunktion mit zumindest stellenweiser Verbindung des Spulendrahts mit dem Substrat und zur Verbindung der Spulendrahtenden mit den Anschlußflächen des Chips eignet sich in besonderer Weise ein Bondkopf, wie er als Wickel/Verbindungs-Vorrichtung in der auf denselben Anmelder zurückgehenden deutschen Patentanmeldung P 43 25 334.2 im Detail beschrieben ist. Dieser Bondkopf weist als integrale Einrichtungen eine Drahtführungseinrichtung, eine Drahtverbindungseinrichtung und eine Drahttrenneinrichtung auf und ist relativ zum Substrat bewegbar. Zur Applikation des Chips kann eine pick-and-place-Einrichtung eingesetzt werden, die mit der vorstehend genannten Verbindungseinrichtung kombiniert werden kann.

Bei der erfindungsgemäßen Chipkarte nach Anspruch 4 ist die Spule als Drahtspule mit einer oder mehreren Spulendrahtwindungen ausgebildet, die in einer Verlegeebene auf dem Substrat angeordnet sind, und eine zumindest stellenweise während der Verlegung hergestellte Verbindung zum Substrat aufweisen.

Die erfindungsgemäße Chipkarte ermöglicht aufgrund ihrer Ausgestaltung eine Herstellung, die die vorstehend bereits erwähnten, mit der Durchführung des erfindungsgemäßen Verfahrens verbundenen Vorteile aufweist; und somit eine gegenüber konventionellen Chipkarten wesentlich vereinfachte Herstellung.

Mit dem Begriff "Chipkarte" sollen hier sämtliche Transponder-Applikationen umfaßt sein, bei denen ein kartenartiges Substrat verwendet wird. Dazu gehören beispielsweise auch Einschub- oder Einsteckkarten, die fest installiert sind und nicht wie Wert- oder Identifikationskarten einem ständigen Handling unterliegen.

Insbesondere führt die Verlegung der einzelnen Spulendrahtwindungen in einer Verlegeebene zu einer insgesamt wesentlich höheren Biegefestigkeit der Spule im Vergleich zu den komplex und räumlich ausgebildeten Wickelspulen. Hierdurch wird die Funktionssicherheit der Chipkarte auch bei häufiger Biegebeanspruchung der Chipkarte wesentlich erhöht.

Darüber hinaus kann die im Verlegeverfahren gebildete Spule beliebig auf dem Substrat verlegt sein, ohne durch vorgegebene Wickelmatrizenformen in ihrer Kontur festgelegt zu sein. Als besonders vorteilhaft erweist es sich in diesem Zusammenhang, wenn die Spulendrahtwindungen zumindest teilweise meanderförmig oder leporelloartig auf dem Substrat verlegt sind. Hierdurch kann insbesondere im Bereich der Hauptbiegeachsen des Substrats eine besonders biegefeste Gestaltung der Spule vorgesehen werden, die die vorstehend bereits erläuterte Betriebssicherheit einer mit einer derartigen Spule versehenen Chipkarte noch weiter erhöht.

Neben der Spule und dem Chip können auf der erfindungsgemäßen Chipkarte noch weitere Bauelemente auf dem Substrat vorgesehen sein. Dies wird möglich, da, wie bereits vorstehend erwähnt, die Ausbildung der "Verlegespule" an kein bestimmtes Verlegemuster gebunden ist, sondern vielmehr die Ausbildung von beliebigen Verlegeformationen möglich ist. Daher können auf dem Substrat komplexe Baugruppen ausgebildet werden, wobei die zwischen den einzelnen Bauelementen vorhandenen Zwischenräume zum Verlegen des Spulendrahts genutzt werden können.

Eine vorteilhafte Variante der Baugruppenausbildung auf dem Substrat besteht darin, eine Folientaste oder eine Folientastatur zu integrieren. Somit ist es möglich, die Transpondereinheit manuell zu aktivieren oder Daten, wie beispielsweise einen Keycode, einzugeben.

Je nach Art der Verwendung der Chipkarte kann das Substrat mit den darauf angeordneten Bauelementen zumindest teilweise mit einer Decklage versehen sein, die als reine Abdeckschicht oder auch als Funktionsschicht, beispielsweise als Werbeträger oder als zusätzliche optische Kennungsschicht, ausgeführt sein kann.

Nachfolgend wird eine bevorzugte Ausführungsform des erfindungsgemäßen Verfahrens sowie eine bevorzugte Ausführungsform der erfindungsgemäßen Chipkarte anhand der Zeichnungen erläutert. Es zeigen:
**Fig. 1** eine Vorrichtung zur Verlegung eines Spulendrahts auf einem Substrat zur Erläuterung einer Ausführungsform der erfindungsgemäßen Verfahrens;
**Fig. 2** eine nach dem in **Fig. 1** beispielhaft dargestellten Verfahren hergestellte, erfindungsgemäße Chipkarte in einer weiteren Ausführungsform;
**Fig. 3** eine weitere Ausführungsform der Chipkarte;
**Fig. 4** noch eine weitere Ausführungsform der Chipkarte;
**Fig. 5** eine Ausführungsform der erfindungsgemäßen Chipkarte mit einer Baugruppenanordnung;
**Fig. 6** eine weitere Ausführungsform der Chipkarte.

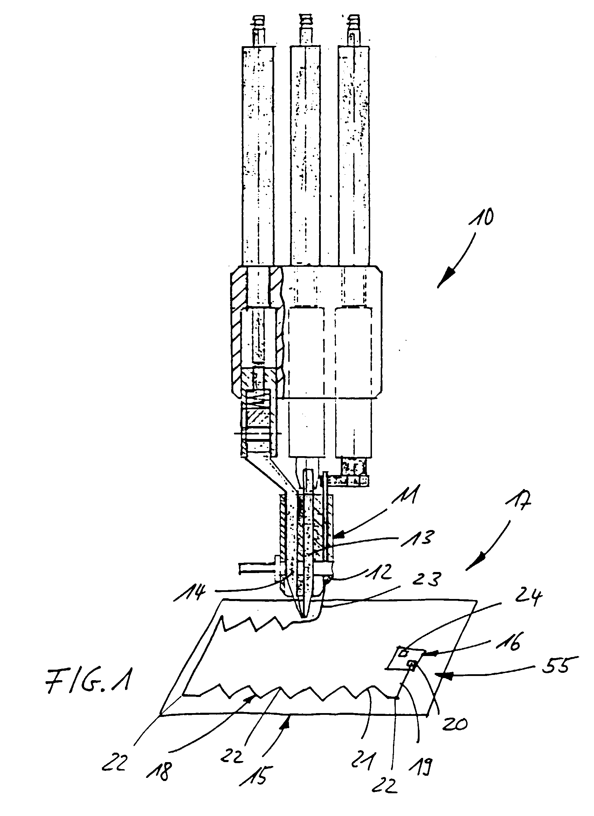

**Fig. 1** zeigt eine Ausführungsform einer Verlege/Verbindungs-Einrichtung 10, wie sie Gegenstand der deutschen Patentanmeldung P 43 25 334.2 ist, mit in einer Werkzeugaufnahme 11 aufgenommenen und darin geführten Werkzeugeinrichtungen, nämlich eine Drahtführungseinrichtung 12, eine Verbindungseinrichtung 13 und eine Drahttrenneinrichtung 14. Die Werkzeugeinrichtungen sowie deren Funktion ist in der vorgenannten Patentanmeldung im Detail beschrieben, so daß im folgenden nicht näher darauf eingegangen werden muß.

Unterhalb der Verlege/Verbindungseinrichtung 10 befindet sich ein kartenförmig ausgebildetes Substrat 15, auf dem ein Chip 16 zur Ausbildung einer Chipkarte 17 angeordnet ist.

Die Applikation des Chips 16 auf das Substrat 15 erfolgt über eine nicht näher dargestellte pick-and-place-Einrichtung, mit der der Chip 16 auf das Substrat 15 aufgebracht werden kann. Die Fixierung des Chips 16 auf dem Substrat 15 kann beispielsweise über einen zuvor auf die Oberfläche des Substrats 15 oder die Unterseite des Chips 16 aufgebrachten Klebeauftrag erfolgen. Der Chip kann auch als Chipmodul zusammen mit einem Chipsubstrat appliziert werden.

Zur Ausbildung einer Spule 18 auf der Chipkarte 17 wird zunächst ein aus der Drahtführungseinrichtung 12 herausgeführtes freies Spulendrahtende 19 mit einer ersten Anschlußfläche 20 des Chips 16 verbunden. Hierzu wird das Spulendrahtende 19 eines aus der Drahtführungseinrichtung 12 herausgeführten Spulendrahts 21 zwischen einer hier als Thermokompressionseinrichtung ausgeführten Verbindungseinrichtung 13 und einer ersten Anschlußfläche 20 des Chips 16 geklemmt und mit dieser verbunden. Zur Verbindung eines relativ dicken Spulendrahts, wie er zur Herstellung von HF-Spulen verwendet wird, und der einen Durchmesser von etwa 100 µm aufweist, mit einer Anschlußfläche hat sich ein Lötverfahren als besonders vorteilhaft erwiesen, wobei die Anschlußflächen des Chips in besonders geeigneter Weise als verzinnte Gold-Bumps ausgeführt sind. Wird als Spulendraht ein auf Grund seiner Zusammensetzung bondfähiger Draht ohne (Backlack-)Isolierung verwendet, ist auch eine unmittelbare Verbindung zwischen dem Spulendraht und den Aluminium-Pads des Chips möglich. Hierbei ist es besonders vorteilhaft, die Verbindung im Ultraschallverfahren oder im Thermokompressionsverfahren herzustellen.

Bei Verwendung von isoliertem Draht kann es vorteilhaft sein, wenn eine Abisolierung des Drahts durch eine in die Verlege-/Verbindungseinrichtung integrierte Abisoliereinrichtung erfolgt. Diese kann mit einer Längenmesseinrichtung kombiniert sein, um die entsprechend der Länge der Verlegespule korrekte Stelle der Abisolierung festzulegen. Bei in die Verlege-/Verbindungseinrichtung integrierter Laser-Verbindungseinrichtung kann diese auch zur Abisolierung verwendet werden.

Ausgehend von der Verbindung des Spulendrahtendes 19 mit der ersten Anschlußfläche 20 erfolgt nun eine Verlegung des Spulendrahts 21 mittels der Verlege/-Verbindungseinrichtung 10. Hierzu wird der Spulendraht 21, wie in Fig. 1 dargestellt, von der Drahtführungseinrichtung 12 teilweise geradlinig und teilweise meanderförmig über die Substratoberfläche geführt, wobei der Spulendraht 21 jeweils bei den Richtungswechseln des Spulendrahtverlaufs auf der Substratoberfläche an Verbindungsstellen 22 mit dem Substrat 15 verbunden wird. Hierzu wird die Drahtführungseinrichtung 12 zusammen mit der Verlege/Verbindungseinrichtung 10 zweiachsig (X,Y-Achsen-Richtung) über die Ebene des Substrats 15 bewegt, wobei an den Verbindungsstellen 22 eine Zustellbewegung (Z-Achsen-Richtung) der Verbindungseinrichtung 13 erfolgt und der Spulendraht temporär zwischen der Verbindungseinrichtung 13 und der Substratoberfläche geklemmt und unter Druck- und Temperatureinwirkung in diese eingeschmolzen wird.

Nach Ausbildung der Spule 18 in der in Fig. 1 dargestellten Art und Weise wird ein aus der Drahtführungseinrichtung 12 herausgeführte laufende Spulendrahtende 23 mit der Verbindungseinrichtung 13 gegen eine zweite Anschlußfläche 24 des Chips 16 geklemmt und mit dieser unter Temperatur- und Druckeinwirkung verbunden. Nachfolgend erfolgt durch ein Ausfahren der Drahttrenneinrichtung 14 ein Abtrennen des laufenden Spulendrahtendes 23, so daß auf der Oberfläche des Substrats 15 nunmehr eine Transpondereinheit 55 aus dem Chip 16 und der mit diesem verbundenen Spule 18 gebildet ist.

Die in **Fig. 1** dargestellte und vorstehend erläuterte Verlege/Verbindungseinrichtung 10 hat in ihrer dargestellten Ausführungsform lediglich beispielhaften Charakter. So kann die Verbindungseinrichtung 13 der Verlege/Verbindungseinrichtung 10 beispielsweise auch als Ultraschallverbindungseinrichtung (Thermosonicverfahren) oder auch als Laserverbindungseinrichtung mit einem Lichtwellenleiter versehen sein, der unter unmittelbarer Anlage oder mittelbar über ein als Andruckelement dienendes Lichtleitelement zur Erzeugung der Verbindungsstellen 22 oder zur Durchführung der Verbindung des Spulendrahts 21 mit den Chipanschlußflächen verwendet wird.

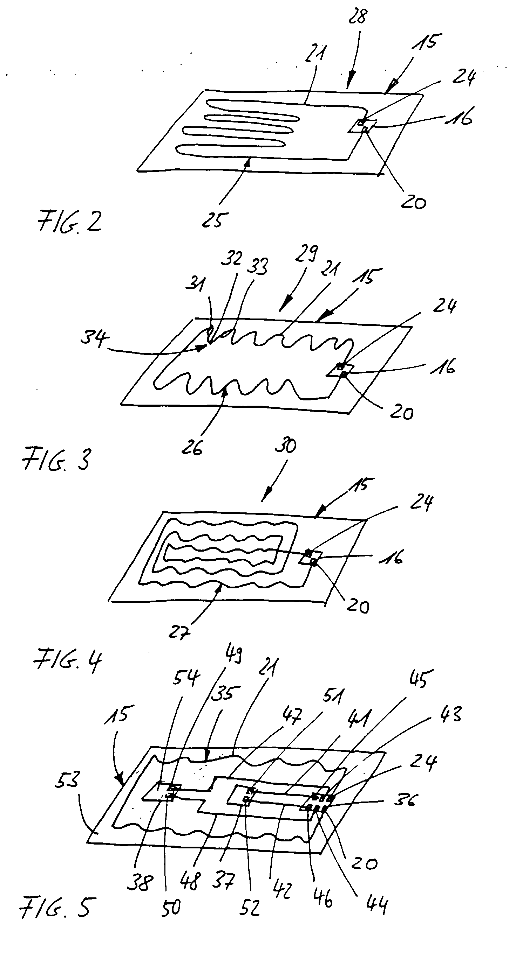

Die **Fig. 2** bis **4** zeigen beispielhaft weitere mögliche Verlegemuster zur Verlegung des Spulendrahts 21 auf der Oberfläche eines Substrats 15 zur Ausbildung von Spulen 25, 26 oder 27 und die Verbindung des Spulendrahts 21 mit den Anschlußflächen 20, 24 des Chips 16, um jeweils unterschiedlich gestaltete Transpondereinheiten 28, 29, 30 auf den Substraten 15 zu erzeugen. Dabei sind zur Erzeugung der hier beispielhaft dargestellten, meanderförmigen Verlegemuster jeweils mehrere Verbindungsstellen 31, 32, 33 zwischen dem Spulendraht 21 und der Oberfläche des Substrats 15 vorgesehen, um Spulendrahtkurven 34 auszubilden.

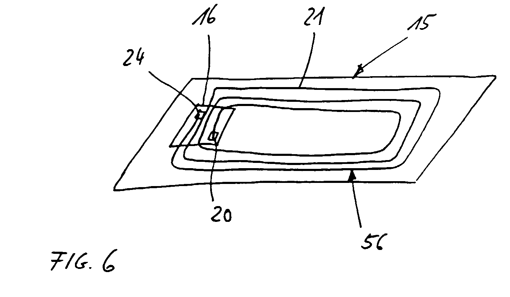

Aus der Darstellung in **Fig. 5** wird deutlich, daß die Verlegung des Spulendrahts 21 auf der Oberfläche des Substrats 15 nicht nur zur Ausbildung einer Spule 35 sondern auch zum Verlegen von Drahtverbindungsstrekken 41, 42, 47, 48 zwischen Anschlußflächen 20, 24, 43 bis 46 und 49 bis 52 einzelner Bauelemente 36, 37 und 38 verwendet werden kann. Bei der in **Fig. 5** beispielhaft dargestellten Bauelementgruppe handelt es sich um einen Chip 36, ein Batterieelement 37 und eine Folientaste 38. Dabei ist der Spulendraht 21 der Spule 35 mit Anschlußflächen 20, 24 verbunden. Die Drahtverbindungsstrecken 41, 42 sind zwischen den Anschlußflächen 43 bzw. 44 des Batterieelements 37 und den Anschlußflächen 45 bzw. 46 des Chips 36 verlegt. Die Drahtverbindungsstrecken 47, 48 verbinden die Anschlußflächen 49 bzw. 50 der Folientaste 38 mit den Anschlußflächen 51 bzw. 52 des Chips 36.

Die Drahtverbindungsstrecken 41, 42 und 47, 48 können wie die Spule 35 aus Spulendraht 21 gebildet sein und ebenso wie der Spulendraht zur Ausbildung der Spule 35 mittels der Verlege/Verbindungseinrichtung 10 auf der Oberfläche des Substrats 15 verlegt und mit den entsprechenden Anschlußflächen der Bauelemente verbunden sein .

Wie durch die schraffierte Fläche in **Fig. 5** angedeutet werden soll, kann die Oberfläche des Substrats 15 mit den darauf applizierten Bauelementen 36, 37 und 38 sowie der Spule 35 und den Drahtverbindungsstrecken 41, 42, 47, 48 mit einer Decklage 53 versehen sein, die lediglich ein Tastfeld 54 der Folientaste 38 freiläßt. Die Decklage 53 kann beispielsweise als Laminatschicht oder auch auf beliebige andere Art und Weise haftend auf die Oberfläche des Substrats 15 aufgebracht sein.

**Fig. 6** zeigt eine Chipkarte, auf der der Spulendraht 21 zur Verlegung einer Spule 56 zunächst mit der Anschlußfläche 20 verbunden ist, dann beim Verlegen der Spule bei jeder Windung über die Oberfläche des Chips 16 hinweggeführt und schließlich mit der zweiten Anschlußfläche 24 verbunden ist. Auf diese Art und Weise ist es nicht notwendig, wie bei Fig. 4 dargestellt, daß der Spulendraht zur Verbindung mit der zweiten Anschlußfläche über die Windungen der Spule hinweggeführt werden muß. Somit lassen sich Chipkarten mit einer besonders geringen Dicke herstellen.

## Patentansprüche

1. Verfahren zur Anordnung einer zumindest einen Chip (16, 36) und eine Drahtspule (18, 35) aufweisenden Transpondereinheit auf einem Substrat, insbesondere einem zur Herstellung einer Chipkarte (17) verwendeten Substrat, bei dem der Chip und die Drahtspule auf dem gemeinsamen Substrat (15) angeordnet werden und die Verbindung von Spulendrahtenden (19, 23) mit Anschlußflächen (20, 24) des Chips auf dem Substrat erfolgt,
dadurch **gekennzeichnet,**
daß die Ausbildung der Spule durch Verlegung eines Spulendrahts (21) in einer Verlegeebne auf dem Substrat unter zumindest stellenweiser Verbindung des Spulendrahts mit dem Substrat erfolgt.

2. Verfahren nach Anspruch 1,
dadurch **gekennzeichnet,**
daß vor der Verlegung des Spulendrahts (21) zunächst eine Verbindung eines Spulendrahtendes (19) mit einer ersten Anschlußfläche (20) des Chips (16, 36), anschließend die Verlegung des Spulendrahts (21) zur Ausbildung der Spule (18, 35), und schließlich die Verbindung des laufenden Spulendrahtendes (23) mit einer zweiten Anschlußfläche (24) des Chips erfolgt, wobei während der Verlegung des Spulendrahts zumindest stellenweise eine Verbindung des Spulendrahts (21) mit dem Substrat (15) erfolgt.

3. Verfahren nach Anspruch 1 oder 2,
dadurch **gekennzeichnet,**
daß während der Applikation des Chips (16, 36) auf dem Substrat (15) eine Verbindung des Chips mit dem Substrat erfolgt.

4. Chipkarte, insbesondere Wertkarte, Identifikationskarte oder dergleichen, mit einer auf einem Substrat (15) angeordneten Transpondereinheit, die zumindest einen Chip (16, 36) und eine Drahtspule (18, 35) aufweist, deren Spulendrahtenden (19, 23) mit Anschlußflächen (20, 24) des Chips verbunden sind und wobei die Drahtspule mit einer oder mehreren Spulendrahtwindungen ausgebildet ist, dadurch gekennzeichnet, daß die Spulendrahtwindungen in einer Verlegeebene auf dem Substrat angeordnet sind, und eine zumindest stellenweise während der Verlegung hergestellte Verbindung zum Substrat aufweisen.

5. Chipkarte nach Anspruch 4,
dadurch **gekennzeichnet,**
daß die Spulendrahtwindungen zumindest teilweise meanderförmig oder leporelloartig auf dem Substrat (15) verlegt sind.

6. Chipkarte nach Anspruch 4 oder 5,
dadurch **gekennzeichnet,**
daß neben der Spule (35) und dem Chip (36) weitere Bauelemente (37, 38) auf dem Substrat (15) angeordnet sind.

7. Chipkarte nach Anspruch 6,
dadurch **gekennzeichnet,**
daß als zumindest ein weiteres Bauelement auf dem Substrat (15) eine Folientaste (38) oder eine Folientastatur angeordnet ist.

8. Chipkarte nach einem oder mehreren der Ansprüche 4 bis 7,
dadurch **gekennzeichnet,**
daß die auf dem Substrat (15) angeordneten Bauelemente (35, 36, 37, 38) zumindest teilweise durch eine mit dem Substrat (15) verbundene Decklage (53) abgedeckt sind.

## Claims

1. Method of arranging a transponder unit comprising at least one chip (16, 36) and one wire coil (18, 35) on a substrate, in particular a substrate used to produce a chip card (17), in which the chip and the wire coil are disposed on the common substrate (15) and the coil wire ends (19, 23) are bonded to terminal pads (20, 24) of the chip on the substrate,
characterized in that
the coil is formed by laying a coil wire (21) in a wiring plane on the substrate, with the coil wire being bonded to the substrate at least at some points.

2. Method according to Claim 1,
characterized in that,
prior to laying the coil wire (21), a coil wire end (19) is first bonded to a first terminal pad (20) of the chip (16, 36), then the coil wire (21) is laid to form the coil (18, 35) and, finally, the running coil wire end (23) is bonded to a second terminal pad (24) of the chip, the coil wire (21) being bonded to the substrate (15) at least at some points during the laying of the coil wire.

3. Method according to Claim 1 or 2,
characterized in that,
during the mounting of the chip (16, 36) on the substrate (15), the chip is bonded to the substrate.

4. Chip card, in particular debit card, identification card or the like, having a transponder unit that is disposed on a substrate (15) and that comprises at least one chip (16, 36) and one wire coil (18, 35) whose coil wire ends (19, 23) are bonded to the terminal pads (20, 24) of the chip and wherein the wire coil is formed with one or more coil wire turns,
characterized in that
the coil wire turns are disposed in a wiring plane on the substrate and have a bond to the substrate made at least at some points during the laying.

5. Chip card according to Claim 4,
characterized in that
the coil wire turns are laid at least partly in meander form or harmonica form on the substrate (15).

6. Chip card according to Claim 4 or 5,
characterized in that,
in addition to the coil (35) and the chip (36), further components (37, 38) are disposed on the substrate (15).

7. Chip card according to Claim 6,
characterized in that
a membrane key (38) or a membrane keypad is disposed on the substrate (15) as at least one further component.

8. Chip card according to one or more of Claims 4 to 7,
characterized in that
the components (35, 36, 37, 38) disposed on the substrate (15) are covered at least partly by an overlay (53) bonded to the substrate (15).

## Revendications

1. Procédé permettant de disposer une unité de transpondeur, comportant au moins une puce (16, 36) et une bobine de fil (18, 35), sur un substrat, notamment un substrat utilisé pour la réalisation d'une carte à puce (17), selon lequel la puce et la bobine sont disposées sur le substrat (15) commun et la liaison des extrémités de fil de bobine (19, 23) avec des surfaces de jonction (20, 24) de la puce a lieu sur le substrat, caractérisé en ce que la réalisation de la bobine a lieu en posant un fil de bobine (21) dans un plan de pose sur le substrat, avec une liaison du fil de bobine avec le substrat qui est effectuée au moins par endroits.

2. Procédé suivant la revendication 1, caractérisé en ce qu'avant la pose du fil de bobine (21), il est d'abord procédé à une liaison d'une extrémité de fil de bobine (19) avec une première surface de jonction (20) de la puce (16, 36), puis à la pose du fil de bobine (21) pour réaliser la bobine (18, 35) et enfin à la liaison de l'extrémité courante de fil de bobine (23) avec une seconde surface de jonction (24) de la puce, une liaison du fil de bobine (21) avec le substrat (15) ayant lieu, au moins par endroits, pendant la pose du fil de bobine.

3. Procédé suivant la revendication 1 ou 2, caractérisé en ce qu'une liaison de la puce avec le substrat a lieu pendant l'application de la puce (16, 36) sur le substrat (15).

4. Carte à puce, notamment carte de crédit, carte d'identification ou analogue, comportant une unité de transpondeur, disposée sur un substrat (15), qui comprend au moins une puce (16, 36) et une bobine de fil (18, 35) dont les extrémités du fil de bobine (19, 23) sont reliées à des surfaces de jonction (20, 24) de la puce, la bobine de fil étant formée d'une ou plusieurs boucles de fil de bobine, caractérisée en ce que les boucles de fil de bobine sont disposées dans un plan de pose sur le substrat et présentent, au moins par endroits, une liaison au substrat réalisée pendant la pose.

5. Carte à puce suivant la revendication 4, caractérisée en ce que les boucles de fil de bobine sont posées, au moins en partie, suivant une forme ondulée ou en zigzag sur le substrat (15).

6. Carte à puce suivant la revendication 4 ou 5, caractérisée en ce que, outre la bobine (35) et la puce (36), d'autres composants (37, 38) sont disposés sur le substrat (15).

7. Carte à puce suivant la revendication 6, caractérisée en ce que, constituant au moins un autre composant, une touche tactile (38) ou un clavier tactile est disposé sur le substrat (15).

8. Carte à puce suivant une ou plusieurs des revendications 4 à 7, caractérisée en ce que les composants (35, 36, 37, 38) disposés sur le substrat (15) sont couverts au moins partiellement par une couche de couverture (53) reliée au substrat (15).
